# EUROPEAN PATENT SPECIFICATION

(11) **EP 1 193 875 B1**
(45) Date of publication and mention of the grant of the patent: **09.11.2005**
(21) Application number: 00402564.9
(22) Date of filing: 15.09.2000
(51) Int. Cl.: H03L 7/099, H03B 5/12, H03J 5/24

(54) **Voltage-controlled oscillator with automatic center frequency calibration**
Spannungsgesteuerter Oszillator mit automatischer Mittenfrequenzeinstellung
Oscillateur de fréquence variable commandé par une tension avec reglage automatique de la fréquence centrale

(43) Date of publication of application: 03.04.2002
(73) Proprietor: ALCATEL, 75008 Paris (FR)
(72) Inventor: Craninckx, Jan Frans Lucien, 3370 Boutersem (BE); Ingels, Mark Maria Albert, 3020 Herent (BE); Op't Eynde, Frank Nico Lieven, 3012 Wilsele (BE); Sevenhans, Joannes Mathilda Josephus, 2930 Brasschaat (BE)
(74) Representative: Narmon, Gisèle Marie Thérèse

(56) References cited:
- EP-A- 0 944 171
- WO-A-00/14880
- GB-A- 2 120 478
- GB-A- 2 337 382
- US-A- 5 686 864
- US-A- 6 091 304
- US-A- 6 114 920

## Description

The present invention relates to a voltage-controlled oscillator including
an oscillator arrangement with a control input, an output terminal and a variable capacitor, said oscillator arrangement being adapted to provide, at said output terminal, an output signal having a frequency that is a function of the value of said variable capacitor, said value being controlled by a control voltage applied to said control input
a calibration device comprising a comparator arrangement coupled to an oscillator control device,
a switchable capacitor arrangement comprising a plurality of switches coupled to capacitors, and
a feedback device having a feedback input to which said output terminal is connected and a feedback output at which said feedback device is adapted to provide said control voltage,
said comparator arrangement having a first input to which said control voltage is applied, at least a second input to which a predetermined reference voltage is applied, and an output connected to a level input of said oscillator control device, and
said oscillator control device having a control output coupled to switch control inputs of said switches, said switches being adapted to connect and to disconnect at least one of said capacitors of said switchable capacitor arrangement in parallel to said variable capacitor, and, in order to control said switches, said oscillator control device being adapted to activate a control signal at said control output if a signal received at said level input indicates that said control voltage has reached said predetermined reference voltage,
said voltage-controlled oscillator being further associated with an external channel controller adapted to control said output signal at said output terminal to have a frequency selected amongst a plurality of predetermined frequencies.

Such a voltage-controlled oscillator is already known in the art, e.g. from the European Patent Application EP-A1-0 944 171. It generally forms part of a Phase Locked Loop [PLL] arrangement wherein the frequency of the output signal has to be selected within a relatively large frequency range. This is for instance the case when the voltage-controlled oscillator is used in mobile telecommunication systems and if different transmission protocols, such as the known Global System for Mobile communications [GSM] at 900 MHz and Digital Enhanced Cordless Telecommunications [DECT] or Digital Crossconnect System [DCS] in the 1,800 MHz frequency band, have to be covered by a same circuit. Since the frequency is dependent of the control voltage, the latter must then also be able to vary within a relatively large voltage range.

Furthermore, due to variations in the processing technology, the frequency of the output signal may shift, for a same control or tuning voltage, from the desired one by a large amount. Here again, a solution of using a large tuning range requires a high supply voltage and/or an abrupt variable capacitor or "varicap". A large tuning range results in a large sensitivity of the voltage-controlled oscillator, which severely influences the surrounding parts of the PLL arrangement.

The trend is now however to reduce the supply voltage in order to reduce accordingly the production cost. Low supply voltage means a reduction of the number of batteries and allows using "deep submicron technology" that permits to reduce the production cost but that can not accept high supply voltages because of risks of break-down.

A problem rising with the reduction of the supply voltage is that a single voltage-controlled oscillator may then no longer reach the limits of the requested frequency range.

A possible solution is to design and fabricate several voltage-controlled oscillators with "center" frequencies shifted by a certain amount. A center frequency is the frequency at which the voltage-controlled oscillator should normally operate and that preferably corresponds to a control voltage having an average value, i.e. in the middle of the supply voltage range. Only the voltage-controlled oscillators having the correct frequency, under the actual technology characteristics, should then be selected and activated. However, such a solution is avoided because of the relatively high cost of the components and results in a non-efficient process.

Another possible solution is to perform a digital calibration of the center frequency with a factory trimming. However, digital factory calibration is costly and does not cover variations over the products lifetime.

The goal is thus to provide a voltage-controlled oscillator adapted to operate with a relatively low power supply, while allowing a large operational frequency range and keeping the production cost low.

This is achieved by the calibration device and the switchable capacitor arrangement of which the switches connect and disconnect capacitors in parallel to the variable capacitor under control of the oscillator control device. To this end, the oscillator control device activates a control signal at the control output if a signal received at the level input indicates that the control voltage has reached the predetermined reference voltage. In other words, when the control voltage reaches the predetermined reference voltage, the fact of adding or removing capacitors in parallel with the variable capacitor of the oscillator arrangement makes the frequency to jump towards another control voltage versus frequency characteristic. As a result, in function of the number of capacitors branched in parallel with the variable capacitor of the oscillator arrangement, different frequencies may be obtained for a same control voltage. This solution allows to increasing the frequency range of a single voltage-controlled oscillator at relatively low cost and is especially useful in low power supply applications.

It is to be noted that in a mobile telecommunication system, such as the GSM, the transmission frequency range is divided into a plurality of channels. As a consequence, different predetermined frequencies are requested at the output of the voltage-controlled oscillator each of these predetermined frequencies corresponding to a particular channel.

An object of the present invention is that each of these predetermined frequencies, corresponding to a particular channel, are obtained very fast, under control of the external channel controller.

According to the invention, this object is achieved due to the fact that said oscillator control device includes a memory arrangement comprising a plurality of memory cells each storing a control signal, that said external channel controller being adapted to control, via a memory control input of said oscillator control device, said memory arrangement to provide, at said control output, one of the control signals stored in said memory cells, and that said feedback device includes a frequency divider adapted to perform a division of the frequency of the output signal received at said feedback input by a value provided by said external channel controller via a control terminal of said feedback device, said feedback device being adapted to provide said control voltage as a function of the result of said division.

In this way, e.g. for a mobile telecommunication system such as the GSM, each predetermined frequency is associated to a particular control signal stored in the memory arrangement. This control signal corresponds to a number or value provided to the frequency divider. When a particular channel is selected by the external channel controller, the associated control signal is immediately provided to the switchable capacitor arrangement for operating the suitable switches. The voltage-controlled oscillator will then immediately switch towards the correct characteristic even when starting from a power-down status. In other words, owing to the memory cells associated to other components of the voltage-controlled oscillator, the channel selected by the external channel controller is obtained in a very fast way.

In a preferred embodiment, the present invention is characterized in that said oscillator control device further includes a learning algorithm module adapted to update the control signals stored in said memory cells according to a selection signal received from said external channel controller.

This optimizes even more the speed for reaching the correct frequency when a particular channel or frequency is selected.

Another characterizing embodiment of the present invention is that said feedback device further has a feedback control input to which a reset output of said oscillator control device is connected, said oscillator control device being adapted to apply a reset pulse to said reset output when said control signal is activated, and that said feedback device is adapted to provide, at said feedback output, said control voltage as a function of the frequency of a signal at said feedback input when no reset pulse is received from said oscillator control device, and to provide said control voltage equal to a predetermined middle reference voltage when a reset pulse is received from said oscillator control device.

When the control voltage changes, say increases, the frequency of the output signal also increases according to a control voltage versus frequency characteristic of the voltage-controlled oscillator. When the control voltage reaches the predetermined reference voltage, the control signal is activated by the oscillator control device and causes the frequency to jump to another control voltage versus frequency characteristic, i.e. to another frequency value. This new frequency value is then generally higher than the requested frequency. This is for instance the case where the control voltage is used for fine-tuning purposes. As a consequence, the control voltage, being then anyway to high and not allowed to increase anymore, needs to be decreased to obtain the correct frequency value. The oscillator control device applying a reset pulse to the reset output when the control signal is activated performs this. This forces the feedback device to provide a control voltage equal to the predetermined middle reference voltage. This new control voltage is lower than the previous one so that it may again increase thereby increasing the frequency of the output signal.

Yet another characterizing embodiment of the present invention is that said comparator arrangement further includes
a first comparator having a first input to which said control voltage is applied, a second input to which a predetermined low reference voltage is applied, and an output connected to a low level input of said oscillator control device,
a second comparator having a first input to which said control voltage is applied, a second input to which a predetermined high reference voltage is applied, and an output connected to a high level input of said oscillator control device,
that the low level input and the high level input form together said level input of said oscillator control device,
that said oscillator control device is adapted to control, via said control output, said switchable capacitor arrangement to connect at least one of said capacitors in parallel to said variable capacitor if said control signal is activated via said low level input, and to disconnect at least one of said capacitors from said variable capacitor if said control signal is activated via said high level input,
and that said predetermined middle reference voltage has an intermediate value between said predetermined low reference voltage and said predetermined high reference voltage.

The predetermined middle reference voltage is thus generally a voltage in the middle of the supply voltage range. This allows the frequency to be changed in both directions, i.e. up or down, starting from an average value.

In a variant embodiment, the present invention is characterized in that said voltage-controlled oscillator further includes a selection device having a first selection input to which said control voltage is applied, a second selection input to which a predetermined middle reference voltage is applied, a selection output connected to the control input of said oscillator arrangement, and a selection control input to which the reset output of said oscillator control device is connected, and that said selection device is adapted to connect said first selection input to said selection output if no reset pulse is received at said selection control input, and to connect said second selection input to said selection output if said reset pulse is received.

This improves the speed of the transfer from one characteristic to another with a reduced frequency jump during the change of the control voltage from the predetermined reference voltage to the predetermined middle reference voltage by the feedback device under control of the activated control signal. This is also useful during a startup phase of the voltage-controlled oscillator. The voltage-controlled oscillator then starts operating with a control voltage in the middle of the supply voltage range. This is called "automatic center frequency calibration" and allows the control voltage to be modified for a same amount up and down from the middle or center frequency.

The present invention also relates to a method to adjust a control voltage of a voltage-controlled oscillator wherein the frequency of an output signal is a function of said control voltage, said method comprising the step of
- controlling the value of a variable capacitor of an oscillator arrangement by means of said control voltage,
- comparing said control voltage with a predetermined reference voltage, and
- controlling the coupling of at least one capacitor in parallel to said variable capacitor when said control voltage reaches said predetermined reference voltage,
said voltage-controlled oscillator being associated with an external channel controller controlling said output signal to have a frequency selected amongst a plurality of predetermined frequencies.

Such a method is already known in the art and is for instance used in the above-mentioned known voltage-controlled oscillator. If the method is used as disclosed therein, the same problem as described above for obtaining in a very fast way a predetermined output frequency still arises and no suitable solution is known.

Another object of the present invention is to provide a method for obtaining very fast a predetermined output frequency, e.g. corresponding to a particular channel of a mobile telecommunication system, under control of the external channel controller.

According to the invention, this other object is achieved due to the fact that the present method further comprises steps of
- storing, for each of said predetermined frequencies, a control signal for controlling capacitors to be coupled in parallel with said variable capacitor, and
- controlling the coupling of said capacitors by means of a stored control signal which corresponds to the frequency selected by said external channel controller.

In this way each predetermined frequency able to be selected by the external channel controller is associated to one of the stored control signals. When a particular channel is selected by the external channel controller the associated control signal immediately controls the coupling of corresponding capacitors. The voltage-controlled oscillator will then immediately switch towards the correct characteristic.

Another characterizing embodiment of the present invention is that the method further comprises a step of updating a stored control signal when said output signal has the frequency selected by said external channel controller.

In this way, the control signal is always updated whereby the voltage-controlled oscillator jumps even faster to the correct output frequency selected by the external channel controller.

It is to be noted that the present method is particularly suited to be applied in the above voltage-controlled oscillator according to the invention.

Further characterizing embodiments of the present voltage-controlled oscillator and of the method for obtaining rapidly the correct output frequency are mentioned in the appended claims.

It is to be noticed that the term 'comprising', used in the claims, should not be interpreted as being restricted to the items listed thereafter. Thus, the scope of the expression 'a device comprising items A and B' should not be limited to devices consisting only of components A and B. It means that with respect to the present invention, the only relevant components of the device are A and B.

Similarly, it is to be noticed that the term 'coupled', also used in the claims, should not be interpreted as being restricted to direct connections only. Thus, the scope of the expression 'a device A coupled to a device B' should not be limited to devices or systems wherein an output of device A is directly connected to an input of device B. It means that there exists a path between an output of A and an input of B which may be a path including other devices, arrangements and/or means.

The above and other objects and features of the invention will become more apparent and the invention itself will be best understood by referring to the following description of an embodiment taken in conjunction with the accompanying drawings wherein:
Fig. 1 represents a voltage-controlled oscillator with automatic center frequency calibration according to the invention;
Fig. 2 shows different control voltage versus frequency characteristics of the voltage-controlled oscillator of Fig. 1; and
Fig. 3 represents a variant of the voltage-controlled oscillator of Fig. 1 with a selection device MX to improve the switching speed.

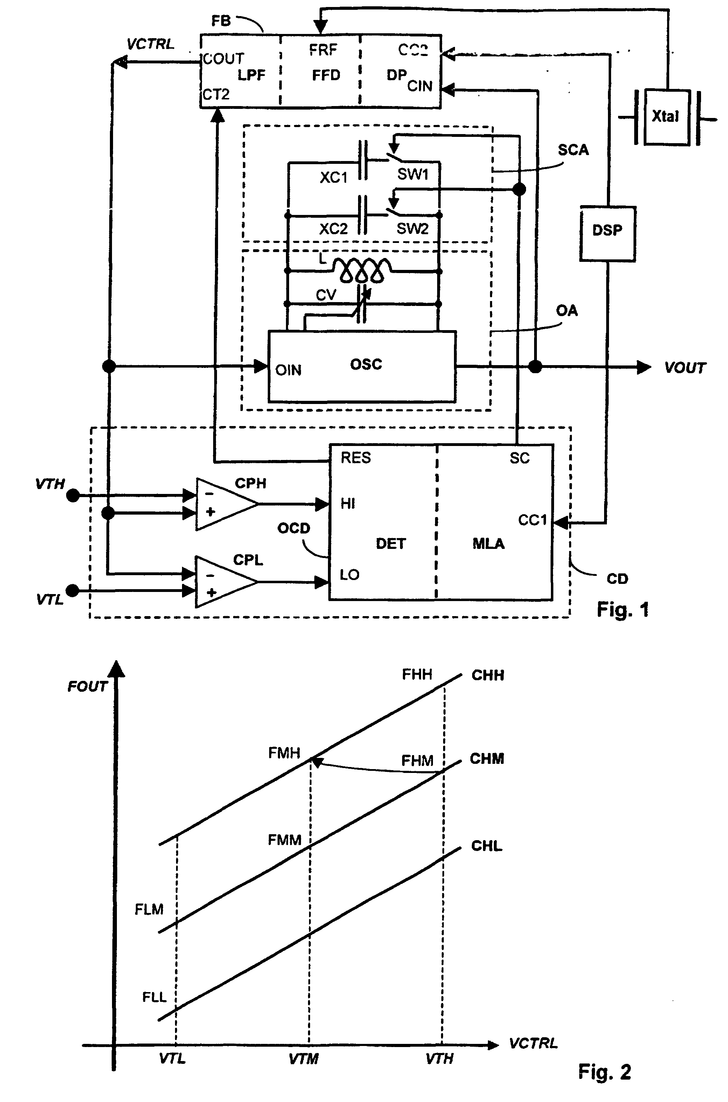

The voltage-controlled oscillator shown at Fig. 1 includes an oscillator arrangement OA comprising an oscillator OSC having an output terminal VOUT at which a like named output signal is provided. The frequency of the output signal VOUT is determined by a control or tuning voltage VCTRL applied to a control input OIN of the oscillator OSC. To provide the output signal VOUT at a predetermined frequency, the oscillator arrangement OA comprises a resonant circuit formed by the parallel connection of an inductance L and a variable capacitor or "varicap' CV. This resonant circuit is coupled to the oscillator OSC in order to operate therewith. The value of the variable capacitor CV is controlled in an analog way by the control voltage VCTRL that is derived from the frequency of the output signal VOUT by a feedback device FB, also included in the present voltage-controlled oscillator.

The feedback device FB has an input CIN to which the output terminal VOUT is connected and an output COUT at which the control voltage VCTRL is provided as a function of the frequency of the output signal VOUT as will be explained in more detail later.

Some operational characteristics CHL, CHM, CHH of control voltage VCTRL versus frequency FOUT of the output voltage VOUT of the voltage-controlled oscillator are represented at Fig. 2. These characteristics correspond to different capacitor values of the resonant circuit of OA. Therein appears that the control voltage VCTRL is allowed to vary within a predetermined voltage range from a low reference voltage VTL up to a high reference voltage VTH. According to the value of the capacitor coupled to the oscillator OSC, the frequency FOUT varies along one of the characteristics CHL, CHM or CHH as will be explained in more detail below.

In order to increase the frequency range wherein the frequency FOUT is allowed to vary, without increasing the voltage range wherein the control voltage VCTRL is allowed to be, a calibration device CD is added to the voltage-controlled oscillator. The calibration device CD includes two comparators CPL and CPH as well as an oscillator control device OCD.

On the one hand, the comparator CPL is a low limit comparator comprising a differential amplifier having an inverting input - at which the control voltage VCTRL is applied and a non-inverting input + at which the low reference voltage VTL is applied. An output of the comparator CPL is connected to a low level input LO of a detection circuit DET forming part of the oscillator control device OCD. On the other hand, the comparator CPH is a high limit comparator also comprising a differential amplifier having a non-inverting input + at which the control voltage VCTRL is applied and an inverting input - at which the high reference voltage VTH is applied. An output of the comparator CPH is connected to a high level input HI of the detection circuit DET of the oscillator control device OCD.

When the control voltage VCTRL reaches one of the limits of the voltage range, i.e. either the lower limit VTL or the upper limit VTH, a signal is provided at a corresponding level input LO or HI of the detection circuit DET by one of the comparators CPL or CPH respectively. The detection circuit DET then activates a control signal and provides it at a detector control output SC of the oscillator control device OCD.

This detector control output SC is connected to control inputs of a switchable capacitor arrangement SCA also included in the voltage-controlled oscillator. The switchable capacitor arrangement SCA is provided with one or more switchable capacitor circuits coupled in parallel, each switchable capacitor circuit comprising the series connection of a switch SW1, SW2 and a capacitor XC1, XC2. The switchable capacitor arrangement SCA shown at Fig. 1 comprises two switchable capacitor circuits SW1, XC1 and SW2, XC2 connected in parallel with the resonant circuit of the oscillator arrangement OA. In this way, the switchable capacitor circuits are connected in parallel across the variable capacitor CV.

To further explain the action of the oscillator control device OCD and of the switchable capacitor arrangement SCA on the operation of the voltage-controlled oscillator, we will consider that a first switchable capacitor circuit, say SW1, XC1, is operational, i.e. with the switch SW1 closed, whilst a second switchable capacitor circuit SW2, XC2 has its switch SW2 open and its capacitor XC2 has thus no effect on the resonant circuit L, CV. This situation will correspond the characteristic CHM at Fig. 2.

As long as the control voltage VCTRL remains within the limits of VTL and VTH, no control signal is activated by the detection circuit DET of the oscillator control device OCD. The oscillator OSC operates then along the characteristic CHM with, as resonant circuit, the parallel connection of the inductance L, the variable capacitor CV and the capacitor XC1.

If, for instance, the control voltage VCTRL increases, the frequency FOUT also increases. When the control voltage VCTRL reaches the high reference voltage VTH corresponding to a frequency FHM of the output signal VOUT, the comparator CPH detects that situation and sends a signal to the high level input HI of the detection circuit DET. In response to this signal, a control signal is activated at the control output SC of the oscillator control device OCD in order to open the switch SW1 of the first switchable capacitor circuit. By opening the switch SW1, the first capacitor XC1 becomes disconnected from the actual resonant circuit, of which the capacitive value is thereby decreased since only the variable capacitor CV remains in parallel with the inductance L. As a result, the control voltage versus frequency characteristic of the voltage-controlled oscillator becomes CHH instead of CHM. The frequency is then immediately increased from FHM to FHH because of the jump from the characteristic CHM to the characteristic CHH for a same control voltage equal to VTH.

If, on the contrary, starting again from the characteristic CHM, the control voltage VCTRL decreases, the frequency FOUT also decreases. When the control voltage VCTRL reaches the low reference voltage VTL, the comparator CPL detects that situation and sends a signal to the low level input LO of the detection circuit DET. In response to this signal, the oscillator control device OCD activates a control signal at its control output SC in order to close the switch SW2 of the second switchable capacitor circuit. By closing the switch SW2, the second capacitor XC2 becomes connected in parallel to the actual resonant circuit, of which the capacitive value is thereby increased to CV + XC1 + XC2. As a result, the control voltage versus frequency characteristic of the voltage-controlled oscillator becomes CHL instead of CHM. The frequency is then immediately decreased from FLM to FLL because of the jump from the characteristic CHM to the characteristic CHL for a same control voltage equal to VTL.

Owing to the two parallel switchable capacitor circuits of the capacitor arrangement SCA coupled over the resonant circuit L, CV of the oscillator arrangement QA, the frequency range of VOUT is increased up to limits going from the lowest frequency FLL of the characteristic CHL to the highest frequency FHH of the characteristic CHH instead of remaining within the limits of only one of these characteristics, e.g. between FLM and FHM on CHM.

It is to be noted that after a "digital" jump from one characteristic to another, e.g. from CHM to CHH in case of an increasing control voltage VCTRL, the latter voltage is no longer allowed to increase, but may still decrease, while in case of a decreasing control voltage VCTRL and a digital jump from CHM to CHL, the control voltage VCTRL is no longer allowed to decrease, but may still increase. Furthermore, this digital change of characteristic causes an abrupt jump on the smooth analog frequency progression along a single characteristic, which in some application, such as for instance for fine-tuning, is unwanted.

The present voltage-controlled oscillator is therefore preferably provided with an automatic center frequency calibration which, by a digital frequency jump, resets the control voltage VCTRL in the middle of the allowed voltage range thereby also resetting the frequency FOUT in the middle of the new characteristic.

To this end, the oscillator control device OCD is provided with a reset output RES whereat a like-named reset pulse is provided when a control signal is activated at the control output SC. The reset output RES is connected to a control input CT2 of the feedback device FB. If, for instance, the control voltage VCRTL, moving upwards on the characteristic CHM, has reached the high reference voltage VTH, a reset pulse is sent by the oscillator control device OCD to the feedback device FB via the respective terminals RES and CT2. Upon reception of the reset pulse, the feedback device FB changes the control voltage VCTRL, at its output COUT, from the high reference voltage VTH to a middle reference voltage VTM. This middle reference voltage VTM preferably has an intermediate or average value between the low reference voltage VTL and the high reference voltage VTH. The middle reference voltage VTM is preferably also in the middle of the supply voltage range. Owing to the new control voltage VCTRL being equal to the middle reference voltage VTM on the characteristic CHH, the frequency FOUT of the output signal VOUT has changed from FHM at the upper limit of the characteristic CHM to FMH in the middle of the characteristic CHH, instead of being changed abruptly to FHH. As can be seen at Fig. 2, the frequencies FHM and FMH are chosen to be substantially equal. As a result, the control voltage VCTRL may continue to increase on the characteristic CHH and there is no longer a frequency jump during the increase of VCTRL first on CHM and then on CHH.

The reset of the control voltage VCTRL towards the middle of the control voltage versus frequency characteristic of the voltage-controlled oscillator is called "automatic center frequency calibration". This reset, bringing the control voltage VCTRL at an intermediate value VTM, further also allows the frequency FOUT to be changed again in both directions, i.e. up or down on the characteristic CHH, starting from the average or middle value FMH.

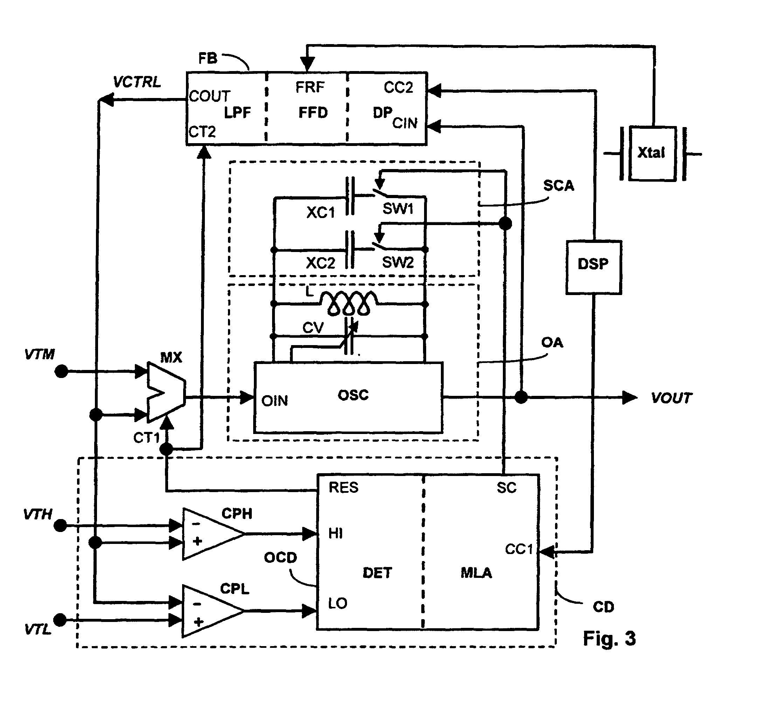

In a variant embodiment of the present voltage-controlled oscillator, shown at Fig. 3, the transition speed of the control voltage VCTRL from a limit value such as VTH to the middle value VTM is further improved owing to the addition of a selection device MX. The selection device MX has a first input to which the control voltage VCTRL, from the feedback output COUT, is applied, and has a second input to which the middle reference voltage equal to VTM is applied. An output of the selection device MX is connected to the control input OIN of the oscillator OSC. MX is further provided with control input CT1 to which the reset output RES of the oscillator control device OCD is connected. By default, i.e. without reset pulse received, the first input of MX is connected to the output thereof, applying so the control voltage VCTRL directly to the control input OIN of the oscillator OSC as in the embodiment shown at Fig. 1.

Owing to this improvement, which also reduces the already small frequency jump from FHM to FMH, either the control voltage VCTRL or the middle reference voltage equal to VTM may be applied to the control input OIN of the oscillator OSC according to the presence or not of a reset pulse RES at the control input CT1 of the selection device MX. When such a reset pulse RES is sent by the oscillator control device OCD, the second input of MX is selected and the middle reference voltage VTM is immediately applied to the control input OIN instead of the control voltage VCTRL. As a result, the frequency FOUT of the output signal VOUT is immediately changed from FHM to FMH. The duration of this relatively fast operation corresponds to the time needed by the feedback device FB to change the control voltage VCTRL at its output COUT from VTH to VTM. This is also useful during a startup phase of the voltage-controlled oscillator. Indeed, owing to the presence of the selection device MX, the voltage-controlled oscillator always starts operating with a control voltage in the middle of the supply voltage range.

The present voltage-controlled oscillator is also particularly suited for mobile telecommunication applications such as for the Global System for Mobile communications GSM. The GSM system uses 125 channels of 200 kHz each, distributed over the frequency range of 935 MHz to 960 MHz. The use of the channels is controlled by an external channel controller DSP as shown in the Figs. 1 and 3. Each channel corresponds to a particular frequency of the output signal VOUT.

According to the above, each channel may be associated to a particular characteristic, for instance to characteristics such as CHH, CHM or CHL shown at Fig. 2. To this end, each channel also corresponds to a particular position of the switches in the switchable capacitor arrangement SCA, and these positions are controlled by the control signal at the control output SC of the oscillator control device OCD. The 125 control signals, each corresponding to a distinct channel, are then advantageously stored in 125 distinct memory cells of a memory MLA belonging to the oscillator control device OCD of the calibration device CD. Each channel is further associated to a channel code. This channel code is provided by the channel controller DSP to an input CC1 of OCD in order to select the appropriate memory cell in the memory MLA and to extract therefrom the control signal to be applied at the control output SC. An output signal with the correct frequency is then immediately provided at the output terminal VOUT of the voltage-controlled oscillator.

The channel code is further also applied to control input CC2 of the feedback device FB. This feedback device FB comprises, between the feedback input CIN and the feedback output COUT, the cascade connection of a frequency divider DP, a phase/frequency detector FFD and a loop filter LPF. The frequency divider DP has the input CIN at which it receives the output signal VOUT at a frequency selected by the channel controller DSP. DP further has the control input CC2 at which it received the channel code from the channel controller DSP. As the feedback device FD internally always operates at a same frequency, this internal frequency is obtained in the frequency divider DP by dividing the frequency of the incoming signal at CIN by the channel code at the control input CC2. The resulting signal is then provided to the phase/frequency detector FFD of FD.

The phase/frequency detector FFD has control input FRF at which it receives a reference frequency signal, e.g. from a crystal oscillator Xtal. The phase/frequency detector FFD generates a feedback control signal that is a function of difference, in phase or in frequency, between the frequency of the output signal of the frequency divider DP and the reference frequency received at the control input FRF. This feedback control signal is applied to the loop filter LPF of the feedback device FD that, therewith, provides the control voltage VCTRL at the feedback output COUT.

Owing to the memory cells storing control signals associated to the different possible output signals to be provided at the output terminal VOUT, the voltage-controlled oscillator will immediately reach a steady state, even when starting from a power-down status.

The present voltage-controlled oscillator preferably also includes a learning algorithm module associated to the memory MLA of the oscillator control device OCD of the calibration device CD. For each channel or output frequency selected by the channel controller DSP, the learning algorithm module detects the control signal really applied to the control output SC of the oscillator control device OCD. As mentioned above, this control signal is first extracted from a memory cell associated to the channel code received from DSP, but may then be adjusted by the control signal VCTRL provided by the feedback device FD. The purpose of the learning algorithm module is to update the contents of the memory cell with the control signal really applied to the control output SC.

The learning algorithm module optimizes the speed for reaching the correct frequency, and thus the above steady state, when a particular channel or frequency is selected by the channel controller DSP.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is made only by way of example and not as a limitation on the scope of the invention, as defined in the appended claims.

## Claims

1. Voltage-controlled oscillator including
an oscillator arrangement (OA: OSC, CV, L) with a control input (OIN), an output terminal (VOUT) and a variable capacitor (CV), said oscillator arrangement being adapted to provide, at said output terminal, an output signal having a frequency that is a function of the value of said variable capacitor, said value being controlled by a control voltage (VCTRL) applied to said control input,
a calibration device (CD: OCD, CPL, CPH) comprising a comparator arrangement (CPL, CPH) coupled to an oscillator control device (OCD),
a switchable capacitor arrangement (SCA: SW1, XC1; SW2, XC2) comprising a plurality of switches (SW1, SW2) coupled to capacitors (XC1, XC2), and
a feedback device (FB) having a feedback input (CIN) to which said output terminal (VOUT) is connected and a feedback output (COUT) at which said feedback device is adapted to provide said control voltage (VCTRL),
said comparator arrangement (CPL, CPH) having a first input to which said control voltage (VCTRL) is applied, at least a second input to which a predetermined reference voltage (VTL, VTH) is applied, and an output connected to a level input (LO, HI) of said oscillator control device (OCD), and
said oscillator control device (OCD) having a control output (SC) coupled to switch control inputs of said switches (SW1, SW2), said switches being adapted to connect and to disconnect at least one of said capacitors (XC1, XC2) of said switchable capacitor arrangement in parallel to said variable capacitor (CV), and, in order to control said switches, said oscillator control device (OCD) being adapted to activate a control signal at said control output (SC) if a signal received at said level input (LO, HI) indicates that said control voltage (VCTRL) has reached said predetermined reference voltage (VTL, VTH),
said voltage-controlled oscillator being further associated with an external channel controller (DSP) adapted to control said output signal at said output terminal (VOUT) to have a frequency selected amongst a plurality of predetermined frequencies,
**characterized in that** said oscillator control device (OCD) includes a memory arrangement (MLA) comprising a plurality of memory cells each storing a control signal,
**in that** said external channel controller (DSP) being adapted to control, via a memory control input (CC1) of said oscillator control device, said memory arrangement to provide, at said control output (SC), one of the control signals stored in said memory cells,
**and in that** said feedback device (FB) includes a frequency divider (DP) adapted to perform a division of the frequency of the output signal received at said feedback input (CIN) by a value provided by said external channel controller (DSP) via a control terminal (CC2) of said feedback device (FB), said feedback device being adapted to provide said control voltage (VCTRL) as a function of the result of said division.

2. Voltage-controlled oscillator according to claim 1,
**characterized in that** said oscillator control device (OCD) further includes a learning algorithm module adapted to update the control signals stored in said memory cells according to a selection signal received from said external channel controller (DSP).

3. Voltage-controlled oscillator according to claim 1,
**characterized in that** said feedback device (FB) further has a feedback control input (CT2) to which a reset output (RES) of said oscillator control device (OCD) is connected, said oscillator control device being adapted to apply a reset pulse to said reset output when said control signal is activated,
**and in that** said feedback device (FB) is adapted to provide, at said feedback output (COUT), said control voltage (VCTRL) as a function of the frequency of a signal at said feedback input (CIN) when no reset pulse is received from said oscillator control device (OCD), and to provide said control voltage equal to a predetermined middle reference voltage (VTM) when a reset pulse is received from said oscillator control device.

4. Voltage-controlled oscillator according to claim 3,
**characterized in that** said comparator arrangement (CPL, CPH) further includes
a first comparator (CPL) having a first input (-) to which said control voltage (VCTRL) is applied, a second input (+) to which a predetermined low reference voltage (VTL) is applied, and an output connected to a low level input (LO) of said oscillator control device (OCD),
a second comparator (CPH) having a first input (+) to which said control voltage (VCTRL) is applied, a second input (-) to which a predetermined high reference voltage (VTH) is applied, and an output connected to a high level input (HI) of said oscillator control device (OCD),
**in that** the low level input (LO) and the high level input (HI) form together said level input (LO, HI) of said oscillator control device (OCD),
**in that** said oscillator control device (OCD) is adapted to control, via said control output (SC), said switchable capacitor arrangement (SCA: SW1, XC1; SW2, XC2) to connect at least one of said capacitors (XC1, XC2) in parallel to said variable capacitor (CV) if said control signal is activated via said low level input (LO), and to disconnect at least one of said capacitors (XC1, XC2) from said variable capacitor (CV) if said control signal is activated via said high level input (HI).
**and in that** said predetermined middle reference voltage (VTM) has an intermediate value between said predetermined low reference voltage (VTL) and said predetermined high reference voltage (VTH).

5. Voltage-controlled oscillator according to claim 1,
**characterized in that** said voltage-controlled oscillator further includes a selection device (MX) having a first selection input to which said control voltage (VCTRL) is applied, a second selection input to which a predetermined middle reference voltage (VTM) is applied, a selection output connected to the control input (OIN) of said oscillator arrangement (OA: OSC, CV, L), and a selection control input (CT1) to which a reset output (RES) of said oscillator control device (OCD) is connected, said oscillator control device being adapted to apply a reset pulse to said reset output when said control signal is activated,
**and in that** said selection device (MX) is adapted to connect said first selection input to said selection output if no reset pulse is received at said selection control input (CT1), and to connect said second selection input to said selection output if said reset pulse is received.

6. Voltage-controlled oscillator according to claim 1,
**characterized in that** said feedback device (FB) further includes a phase/frequency detector (FFD) and a loop filter (LPF),
**in that** said phase/frequency detector (FFD) is adapted to provide a feedback control signal as a function of the difference between a frequency resulting from said division performed by said frequency divider (DP) and a reference frequency received at a reference frequency input terminal (FRF) of said feedback device,
**and in that** said loop filter (LPF) is adapted to provide said control voltage (VCTRL) as derived from said feedback control signal received from said phase/frequency detector (FFD).

7. Method to adjust a control voltage (VCTRL) of a voltage-controlled oscillator wherein the frequency of an output signal (VOUT) is a function of said control voltage, said method comprising the step of
- controlling the value of a variable capacitor (CV) of an oscillator arrangement (OA: OSC, CV, L) by means of said control voltage (VCTRL),
- comparing said control voltage (VCTRL) with a predetermined reference voltage (VTL, VTH), and
- controlling the coupling of at least one capacitor (XC1, XC2) in parallel to said variable capacitor (CV) when said control voltage (VCTRL) reaches said predetermined reference voltage (VTL, VTH),
said voltage-controlled oscillator being associated with an external channel controller (DSP) controlling said output signal (VOUT) to have a frequency selected amongst a plurality of predetermined frequencies,
**characterized in that** said method further comprises steps of
- storing (MLA), for each of said predetermined frequencies, a control signal for controlling capacitors (XC1, XC2) to be coupled in parallel with said variable capacitor (CV), and
- controlling the coupling of said capacitors by means of a stored control signal which corresponds to the frequency selected by said external channel controller (DSP).

8. Method according to claim 7, **characterized in that** said method further comprises a step of updating a stored control signal when said output signal (VOUT) has the frequency selected by said external channel controller (DSP).

9. Method according to claim 7, **characterized in that** said method comprises steps of
- deriving said control voltage (VCTRL) from the frequency of said output signal (VOUT), applied to a feedback device (FB) that divides the frequency of said output signal by a value provided by said external channel controller (DSP),
- comparing the frequency resulting from the division with a reference frequency (Xtal), and
- generating said control voltage (VCTRL) as a result of the difference of the comparison.

10. Method according to claim 7,
**characterized in that** said method comprises steps of
- comparing said control voltage (VCTRL) with a predetermined low reference voltage (VTL) and with a predetermined high reference voltage
- connecting at least one capacitor (XC1, XC2) in parallel to said variable capacitor (CV) if said control voltage (VCTRL) reaches said predetermined low reference voltage (VTL), and
- disconnecting at least one capacitor (XC1, XC2) from said variable capacitor (CV) if said control voltage (VCTRL) reaches said predetermined high reference voltage (VTH),
**and in that** the frequency of said output signal, immediately after the connecting said capacitor (XC1, XC2), is substantially equal to the frequency of said output signal immediately before connecting said capacitor.

## Patentansprüche

1. Spannungsgesteuerter Oszillator, bestehend aus:
einem Oszillatoraufbau (OA: OSC, CV, L) mit einem Steuereingang (OIN), einem Ausgangsanschluss (VOUT) und einem variablen Kondensator (CV), wobei der genannte Oszillatoraufbau entsprechend angeordnet ist, um an den genannten Ausgangsanschluss ein Ausgangssignal mit einer Frequenz zu liefern, die eine Funktion des Wertes des genannten variablen Kondensators ist, wobei der genannte Wert von einer Steuerspannung (VCTRL) gesteuert wird, die am genannten Steuereingang anliegt,
einer Kalibriervorrichtung (CD: OCD, CPL, CPH), bestehend aus einem Komparatoraufbau (CPL, CPH), der an eine Oszillator-Steuervorrichtung (OCD) gekoppelt ist,
einem schaltbaren Kondensatoraufbau (SCA: SW1, XC1, SW2, XC2), bestehend aus einer Vielzahl von Schaltern (SW1, SW2), die an Kondensatoren (XC1, XC2) gekoppelt sind, und
einer Rückkopplungsvorrichtung (FB) mit einem Rückkopplungseingang (CIN), an dem der genannte Ausgangsanschluss (VOUT) angeschlossen ist, und einem Rückkopplungsausgang (COUT), an dem die genannte Rückkopplungsvorrichtung entsprechend angeordnet ist, um die genannte Steuerspannung (VCTRL) zu liefern,
wobei der genannte Komparatoraufbau (CPL, CPH) einen ersten Eingang aufweist, an dem die genannte Steuerspannung (VCTRL) anliegt, mindestens einen zweiten Eingang, an dem eine vordefinierte Referenzspannung (VTL, VTH) anliegt, und einen Ausgang, der an einen Bezugssignal-Eingang (LO, HI) der genannten Oszillator-Steuervorrichtung (OCD) angeschlossen ist, und
der genannten Steuervorrichtung (OCD) mit einem Steuerausgang (SC), der entsprechend gekoppelt ist, um die Steuereingänge der genannten Schalter (SW1, SW2) zu schalten, wobei die genannten Schalter entsprechend angeordnet sind, um mindestens einen der genannten Kondensatoren (XC1, XC2) des genannten schaltbaren Kondensatoraufbaus parallel zu dem genannten variablen Kondensator (CV) zu schalten und zu unterbrechen und um die genannten Schalter zu steuern, wobei die genannte Oszillator-Steuervorrichtung (OCD) entsprechend ausgeführt ist, um ein Steuersignal an dem genannten Steuerausgang (SC) zu aktivieren, wenn ein an dem genannten Bezugssignal-Eingang (LO, HI) empfangenes Signal anzeigt, dass die genannte Steuerspannung (VCTRL) die vordefinierte Steuerspannung (VTL, VTH) erreicht hat,
wobei der genannte spannungsgesteuerte Oszillator außerdem mit einer externen Kanalsteuereinheit (DSP) verbunden ist, die entsprechend ausgeführt ist, um das genannte Ausgangssignal an dem genannten Ausgangsanschluss (VOUT) zu steuern, um eine unter einer Vielzahl von vordefinierten Frequenzen gewählte Frequenz zu wählen,
**dadurch gekennzeichnet, dass** die genannte Oszillator-Steuervorrichtung (OCD) eine Speicheranordnung (MLA) umfasst, die aus einer Vielzahl von Speicherzellen besteht, die jeweils ein Steuersignal speichern,
**dadurch, dass** die genannte externe Kanalsteuereinheit (DSP) entsprechend ausgeführt ist, um über einen Speicher-Steuereingang (CC1) der genannten Oszillator-Steuervorrichtung die genannte Speicheranordnung zu steuern, um an dem genannten Steuerausgang (SC) eines der in den genannten Speicherzellen gespeicherten Steuersignale zu liefern,
**und dadurch, dass** die genannte Rückkopplungsvorrichtung (FB) einen Frequenzteiler (DP) umfasst, der in der Lage ist, eine Teilung der Frequenz des empfangenen Ausgangssignals an dem genannten Rückkopplungseingang (CIN) durch einen Wert vorzunehmen, der über einen Steueranschluss (CC2) der genannten Rückkopplungsvorrichtung (FB) von der genannten externen Kanalsteuereinheit (DSP) geliefert wird, wobei die genannte Rückkopplungsvorrichtung in der Lage ist, die genannte Steuerspannung (VCTRL) als Funktion des Ergebnisses der genannten Teilung zu liefern.

2. Spannungsgesteuerter Oszillator gemäß Anspruch 1,
**dadurch gekennzeichnet, dass** die genannte Oszillatorvorrichtung (OCD) außerdem ein Lernalogrithmus-Modul umfasst, das in der Lage ist, die in den genannten Speicherzellen gespeicherten Steuersignale in Übereinstimmung mit einem Wahlsignal zu aktualisieren, das von der genannten externen Kanalsteuereinheit (DSP)geliefert wird.

3. Spannungsgesteuerter Oszillator gemäß Anspruch 1,
**dadurch gekennzeichnet, dass** die genannte Rückkopplungsvorrichtung (FB) außerdem einen Rückkopplungs-Steuereingang (CT2) aufweist, an den ein Rücksetzausgang (RES) der genannten Oszillator-Steuervorrichtung (OCD) angeschlossen ist, wobei die genannte Oszillator-Steuervorrichtung in der Lage ist, an dem genannten Rücksetzausgang einen Rücksetzimpuls anzulegen, wenn das genannte Steuersignal aktiviert wird,
und **dadurch**, dass die genannte Rückkopplungsvorrichtung (FB) in der Lage ist, die genannte Steuerspannung (VCTRL) an den genannten Rückkopplungsausgang (COUT) als Funktion der Frequenz eines Signals an den genannten Rückkopplungseingang (CIN) zu liefern, wenn kein Rücksetzimpuls von der genannten Oszillator-Steuervorrichtung (OCD) empfangen wird, und die genannte Steuerspannung gleich einer vordefinierten Referenz-Mittenspannung (VTM) zu liefern, wenn ein Rücksetzimpuls von der genannten Oszillator-Steuervorrichtung empfangen wird.

4. Spannungsgesteuerter Oszillator gemäß Anspruch 3,
**dadurch gekennzeichnet, dass** der genannte Komparatoraufbau (CPL, CPH) außerdem umfasst:
einen ersten Komparator (CPL) mit einem ersten Eingang (-), an dem die genannte Steuerspannung (VCTRL) anliegt, einem zweiten Eingang (+), an dem eine vordefinierte, untere Referenzspannung (VTL) anliegt, und einem Ausgang, der an einen unteren Bezugssignal-Eingang (LO) der genannten Oszillator-Steuervorrichtung (OCD) angeschlossen ist,
einen zweiten Komparator (CPH) mit einem ersten Eingang (+), an dem die genannte Steuerspannung (VCTRL) anliegt, einem zweiten Eingang (-), an dem eine vordefinierte, obere Referenzspannung (VTH) anliegt, und einem Ausgang, der an einen oberen Bezugssignal-Eingang (HI) der genannten Oszillator-Steuervorrichtung (OCD) angeschlossen ist,
**dadurch**, dass der untere Bezugssignal-Eingang (LO) und der obere Bezugssignal-Eingang (HI) zusammen den genannten Bezugssignal-Eingang (LO, HI) der genannten Oszillator-Steuervorrichtung (OCD) bilden,
**dadurch, dass** die genannte Oszillator-Steuervorrichtung (OCD) in der Lage ist den genannten schaltbaren Kondensatoraufbau (SCA: SW1, XC1, SW2, XC2) über den genannten Steuerausgang (SC) zu steuern, um mindestens einen der genannten Kondensatoren (XC1, XC2) parallel mit dem genannten variablen Kondensator (CV) zu verbinden, wenn das genannte Steuersignal über den genannten unteren Bezugssignal-Eingang (LO) aktiviert wird, und mindestens einen der genannten Kondensatoren (XC1, XC2) von dem genannten variablen Kondensator (CV) zu trennen, wenn das genannte Steuersignal über den genannten oberen Bezugssignal-Eingang (HI) aktiviert wird,
und **dadurch**, **dass** die genannte, vordefinierte Referenz-Mittenspannung (VTM) einen Zwischenwert zwischen der genannten, vordefinierten unteren Referenzspannung (VTL) und der genannten, vordefinierten oberen Referenzspannung (VTH) aufweist.

5. Spannungsgesteuerter Oszillator gemäß Anspruch 1,
**dadurch gekennzeichnet, dass** der genannte spannungsgesteuerte Oszillator außerdem eine Wahlvorrichtung (MX) mit einem ersten Wahleingang, an dem die genannte Steuerspannung (VCTRL) anliegt, und einem zweiten Eingang, an dem eine vordefinierte Referenz-Mittenspannung (VTM) anliegt, einen Wahlausgang, der an den Steuereingang (OIN) der genannten Oszillator-Anordnung (OA: OSC, CV, L) angeschlossen ist, und einen Wahlsteuereingang (CT1) umfasst, an den ein Rücksetzausgang (RES) der genannten Oszillator-Steuervorrichtung (OCD) angeschlossen wird, wobei die genannte Oszillator-Steuervorrichtung in der Lage ist, einen Rücksetzimpuls an den genannten Rücksetzausgang anzulegen, wenn das genannte Steuersignal aktiviert wird,
und **dadurch**, **dass** die genannte Wahlvorrichtung (MX) in der Lage ist, den genannten ersten Wahleingang mit dem genannten Wahlausgang zu verbinden, wenn kein Rücksetzimpuls an dem genannten Wahlsteuereingang (CT1) empfangen wird, und den genannten zweiten Wahlsteuereingang mit dem genannten Wahlausgang zu verbinden, wenn der genannte Rücksetzimpuls aktiviert wird.

6. Spannungsgesteuerter Oszillator gemäß Anspruch 1,
**dadurch gekennzeichnet, dass** die genannte Rückkopplungsvorrichtung (FB) außerdem einen Phasen-Frequenzdemodulator (FFD) und einen Schleifenfilter (LPF) umfasst,
**dadurch, dass** der genannte Phasen-Frequenzdemodulator (FFD) in der Lage ist, ein Rückkopplungs-Steuersignal als Funktion der Differenz zwischen einer Frequenz, die sich aus der genannten Teilung ergibt, die von dem genannten Frequenzteiler (DP) durchgeführt wurde, und einer Referenzfrequenz zu liefern, die an einem Referenzfrequenz-Eingangsanschluss (FRF) der genannten Rückkopplungsvorrichtung eingeht,
und **dadurch**, **dass** der genannte Schleifenfilter (LPF) in der Lage ist, die genannte Steuerspannung (VCTRL) zu liefern, die von dem genannten Rückkopplungs-Steuersignal abgeleitet wird, das von dem genannten Phasen-Frequenzdemodulator (FFD) empfangen wird.

7. Verfahren zur Einstellung einer Steuerspannung (VCTRL) eines spannungsgesteuerten Oszillators, wobei die Frequenz eines Ausgangssignals (VOUT) eine Funktion der genannten Steuerspannung darstellt, und das genannte Verfahren aus folgenden Schritten besteht:
- Steuerung des Wertes eines variablen Kondensators (CV) eines Oszillator-Aufbaus (OA: OSC, CV, L) mittels der genannten Steuerspannung (VCTRL),
- Vergleich der genannten Steuerspannung (VCTRL) mit einer vordefinierten Referenzspannung (VTL, VTH), und
- Steuerung der Kopplung mindestens eines Kondensators (XC1, XC2) parallel zu dem genannten Kondensator (CV), wenn die genannte Steuerspannung (VCTRL) die genannte, vordefinierte Referenzspannung (VTL, VTH) erreicht,
wobei der genannte spannungsgesteuerte Oszillator mit einer externen Kanalsteuereinheit (DSP) verbunden ist, die das genannte Ausgangssignal (VOUT) steuert, um eine Frequenz aus einer Vielzahl an vordefinierten Frequenzen auszuwählen,
**dadurch gekennzeichnet, dass** das genannte Verfahren außerdem die folgenden Schritte umfasst:
- Speicherung (MLA) eines Steuersignals zur Steuerung der Kondensatoren (XC1, XC2) für jede der genannten, vordefinierten Frequenzen, die parallel zu dem genannten variablen Kondensator (CV) gekoppelt werden sollen, und
- Steuerung der Kopplung der genannten Kondensatoren mittels eines gespeicherten Steuersignals, das der von der externen Kanalsteuereinheit (DSP) ausgewählten Frequenz entspricht.

8. Verfahren gemäß Anspruch 7, **dadurch gekennzeichnet, dass** das genannte Verfahren außerdem einen Schritt zur Aktualisierung eines gespeicherten Steuersignals enthält, wenn das genannte Ausgangssignal (VOUT) die von der genannten externen Kanalsteuereinheit (DSP) gewählte Frequenz aufweist.

9. Verfahren gemäß Anspruch 7, **dadurch gekennzeichnet, dass** das genannte Verfahren folgende Schritte umfasst:
- Ableitung der genannten Steuerspannung (VCTRL) von der Frequenz des genannten Ausgangssignals (VOUT), das auf eine Rückkopplungsvorrichtung (FB) angewendet wird, die die Frequenz des genannten Ausgangssignals durch einen Wert teilt, der von der genannten externen Kanalsteuereinheit (DSP) geliefert wird,
- Vergleich der Frequenz, die sich aus der Teilung ergibt, mit einer Referenzfrequenz (Xtal), und
- Erzeugung der genannten Steuerspannung (VCTRL) als Ergebnis der Differenz aus dem Vergleich.

10. Verfahren gemäß Anspruch 7,
**dadurch gekennzeichnet, dass** das genannte Verfahren folgende Schritte umfasst:
- Vergleich der genannten Steuerspannung (VCTRL) mit einer vordefinierten, unteren Referenzspannung (VTL) und mit einer vordefinierten, oberen Referenzspannung (VTH),
- Anschluss mindestens eines Kondensators (XC1, XC2) parallel zu dem genannten variablen Kondensator (CV), wenn die genannte Steuerspannung (VCTRL) die genannte vordefinierte, untere Referenzspannung (VTL) erreicht, und
- Trennung mindestens eines Kondensators (XC1, XC2) von dem genannten variablen Kondensator (CV), wenn die genannte Steuerspannung (VCTRL) die genannte vordefinierte, obere Referenzspannung (VTH) erreicht,
**und dadurch, dass** die Frequenz des genannten Ausgangssignals unmittelbar nach dem Anschluss des genannten Kondensators (XC1, XC2) praktisch gleich der Frequenz des genannten Ausgangssignals unmittelbar vor dem Anschluss des genannten Kondensators ist.

## Revendications

1. Oscillateur commandé par tension comprenant :
un arrangement d'oscillateur (OA : OSC, CV, L) avec une entrée de commande (OIN), une borne de sortie (VOUT) et un condensateur variable (CV), ledit arrangement d'oscillateur étant adapté pour délivrer, au niveau de ladite borne de sortie, un signal de sortie ayant une fréquence qui est une fonction de la valeur dudit condensateur variable, la valeur étant contrôlée par une tension de commande (VCTRL) appliquée à ladite entrée de commande,
un dispositif de réglage (CD : OCD, CPL, CPH) comprenant un arrangement de comparateur (CPL, CPH) couplé à un dispositif de commande d'oscillateur (OCD),
un arrangement de condensateur commutable (SCA : SW1, XC1 ; SW2, XC2) comprenant une pluralité de commutateurs (SW1, SW2) couplés aux condensateurs (XC1, XC2), et
un dispositif de rétroaction (FB) ayant une entrée de rétroaction (CIN) à laquelle ladite borne de sortie (VOUT) est connectée et une sortie de rétroaction (COUT) à laquelle ledit dispositif de rétroaction est adapté pour fournir ladite tension de commande (VCTRL),
ledit arrangement de comparateur (CPL, CPH) ayant une première entrée à laquelle ladite tension de commande (VCTRL) est appliquée, au moins une seconde entrée à laquelle une tension de référence prédéterminée (VTL, VTH) est appliquée et une sortie connectée à une entrée de niveau (LO, HI) dudit dispositif de commande d'oscillateur (OCD), et
ledit dispositif de commande d'oscillateur (OCD) ayant une sortie de commande (SC) couplée aux entrées de commande de commutation desdits commutateurs (SW1, SW2), lesdits commutateurs étant adaptés pour connecter et pour déconnecter au moins un desdits condensateurs (XC1, XC2) dudit arrangement de condensateur commutable en parallèle au dit condensateur variable (CV) et, de manière à contrôler lesdits commutateurs, ledit dispositif de commande d'oscillateur (OCD) étant adapté pour activer un signal de commande au niveau de ladite sortie de commande (SC) si un signal reçu au niveau de ladite entrée de niveau (LO, HI) indique que ladite tension de commande (VCTRL) a atteint ladite tension de référence prédéterminée (VTL, VTH),
ledit oscillateur commandé par tension étant en outre associé à un contrôleur de canal externe (DSP) adapté pour commander ledit signal de sortie au niveau de ladite borne de sortie (VOUT) pour qu'il ait une fréquence sélectionnée parmi une pluralité de fréquences prédéterminées,
**caractérisé en ce que** ledit dispositif de commande d'oscillateur (OCD) comprend un arrangement de mémoire (MLA) comprenant une pluralité de cellules de mémoire stockant chacune un signal de commande,
**en ce que** ledit contrôleur de canal externe (DSP) étant adapté pour contrôler, via une entrée de commande de mémoire (CC1) dudit dispositif de commande d'oscillateur, ledit arrangement de mémoire pour fournir, au niveau de ladite sortie de commande (SC), un des signaux de commande stockés dans lesdites cellules de mémoire,
et **en ce que** ledit dispositif de rétroaction (FB) comprend un diviseur de fréquence (DP) adapté pour effectuer une division de la fréquence du signal de sortie reçu au niveau de ladite entrée de rétroaction (CIN) par une valeur fournie par ledit contrôleur de canal externe (DSP) via une borne de commande (CC2) dudit dispositif de rétroaction (FB), ledit dispositif de rétroaction étant adapté pour délivrer ladite tension de commande (VCTRL) comme une fonction du résultat de ladite division.

2. Oscillateur commandé par tension selon la revendication 1,
**caractérisé en ce que** ledit dispositif de commande d'oscillateur (OCD) comprend en outre un module d'algorithme d'apprentissage adapté pour mettre à jour les signaux de commande stockés dans lesdites cellules de mémoire en accord avec un signal de sélection reçu dudit contrôleur de canal externe (DSP).

3. Oscillateur commandé par tension selon la revendication 1,
**caractérisé en ce que** ledit dispositif de rétroaction (FB) comprend en outre une entrée de commande de rétroaction (CT2) à laquelle une sortie de réinitialisation (RES) dudit dispositif de commande d'oscillateur (OCD) est connectée, ledit dispositif de commande d'oscillateur étant adapté pour appliquer une impulsion de réinitialisation à ladite sortie de réinitialisation lorsque ledit signal de commande est activé,
et **en ce que** ledit dispositif de rétroaction (FB) est adapté pour délivrer, au niveau de ladite sortie de rétroaction (COUT), ladite tension de commande (VCTRL) comme une fonction de la fréquence d'un signal au niveau de ladite entrée de rétroaction (CIN) lorsque aucune impulsion de réinitialisation n'est reçue depuis le dispositif de commande d'oscillateur (OCD), et pour fournir ladite tension de commande égale à une tension de référence centrale prédéterminée (VTM) lorsqu'une impulsion de réinitialisation est reçue depuis ledit dispositif de commande d'oscillateur.

4. Oscillateur commandé par tension selon la revendication 3,
**caractérisé en ce que** ledit arrangement de comparateur (CPL, CPH) comprend en outre
un premier comparateur (CPL) ayant une première entrée (-) à laquelle ladite tension de commande (VCTRL) est appliquée, une seconde entrée (+) à laquelle une faible tension de référence prédéterminée (VTL) est appliquée, et une sortie connectée à une entrée de bas niveau (LO) du dispositif de commande d'oscillateur (OCD),
un second comparateur (CPH) ayant une première entrée (+) à laquelle ladite tension de commande (VCTRL) est appliquée, une seconde entrée (-) à laquelle une tension de référence prédéterminée élevée (VTH) est appliquée, et une sortie connectée à une entrée de niveau élevé (HI) du dispositif de commande d'oscillateur (OCD),
**en ce que** l'entrée de niveau bas (LO) et l'entrée de niveau élevé (HI) forment ensemble ladite entrée de niveau (LO, HI) dudit dispositif de commande d'oscillateur (OCD),
**en ce que** ledit dispositif de commande d'oscillateur (OCD) est adapté pour commander, via ladite sortie de commande (SC), ledit arrangement de condensateur commutable (SCA : SW1, XC1 ; SW2, XC2) pour connecter au moins un desdits condensateurs (XC1, XC2) en parallèle au dit condensateur variable (CV) si ledit signal de commande est activé via ladite entrée de niveau bas (LO) et pour déconnecter au moins un desdits condensateurs (XC1, XC2) dudit condensateur variable (CV) si ledit signal de commande est activé via ladite entrée de niveau élevé (HI),
et **en ce que** ladite tension de référence centrale prédéterminée (VTM) a une valeur intermédiaire comprise entre ladite tension de référence basse prédéterminée (VTL) et ladite tension de référence élevée prédéterminée (VTH).

5. Oscillateur commandé par tension selon la revendication 1,
**caractérisé en ce que** ledit oscillateur commandé par tension comprend en outre un dispositif de sélection (MX) ayant une première entrée de sélection à laquelle ladite tension de commande (VCTRL) est appliquée, une seconde entrée de sélection à laquelle une tension de référence centrale (VTM) est appliquée, une sortie de sélection connectée à l'entrée de commande (OIN) dudit arrangement d'oscillateur (OA : OSC, CV, L) et une entrée de commande de sélection (CT1) à laquelle une sortie de réinitialisation (RES) dudit dispositif de commande d'oscillateur (OCD) est connectée, ledit dispositif de commande d'oscillateur étant adapté pour appliquer une impulsion de réinitialisation à ladite sortie de réinitialisation lorsque ledit signal de commande est activé,
et **en ce que** ledit dispositif de sélection (MX) est adapté pour connecter ladite première entrée de sélection à ladite sortie de sélection si aucune impulsion de réinitialisation n'est reçue au niveau de l'entrée de commande de sélection (CT1) et pour connecter ladite seconde entrée de sélection à ladite sortie de sélection si ladite impulsion de réinitialisation est reçue.

6. Oscillateur commandé par tension selon la revendication 1,
**caractérisé en ce que** ledit dispositif de rétroaction (FB) comprend en outre un détecteur de phase/fréquence (FFD) et un filtre à boucle (LPF),
**en ce que** ledit détecteur de phase/fréquence (FFD) est adapté pour délivrer un signal de commande de rétroaction sous la forme d'une fonction de la différence entre une fréquence résultant de ladite division effectuée par ledit diviseur de fréquence (DP) et une fréquence de référence reçue au niveau d'une borne d'entrée de fréquence de référence (FRF) dudit dispositif de rétroaction,
et **en ce que** ledit filtre à boucle (LPF) est adapté pour délivrer ladite tension de commande (VCTRL) sous la forme d'une dérivée dudit signal de commande de rétroaction reçu dudit détecteur de phase/fréquence (FFD).

7. Procédé pour ajuster une tension de commande (VCTRL) d'un oscillateur commandé par tension, dans lequel la fréquence d'un signal de sortie (VOUT) est une fonction de ladite tension de commande, ledit procédé comprenant les étapes consistant à :
contrôler la valeur d'un condensateur variable (CV) d'un arrangement d'oscillateur (OA : OSC, CV, L) au moyen de ladite tension de commande (VCTRL),
comparer ladite tension de commande (VCTRL) à une tension de référence prédéterminée (VTL, VTH), et
contrôler le couplage d'au moins un condensateur (XC1, XC2) en parallèle avec ledit condensateur variable (CV) lorsque ladite tension de commande (VCTRL) atteint ladite tension de référence prédéterminée (VTL, VTH),
ledit oscillateur commandé par tension étant associé à un contrôleur de canal externe (DSP) contrôlant ledit signal de sortie (VOUT) pour avoir une fréquence sélectionnée parmi une pluralité de fréquences prédéterminées,
**caractérisé en ce que** ledit procédé comprend en outre les étapes consistant à :
stocker (MLA), pour chacune desdites fréquences prédéterminées, un signal de commande pour commander les condensateurs (XC1, XC2) devant être couplés en parallèle avec ledit condensateur variable (CV), et
contrôler le couplage desdits condensateurs au moyen d'un signal de commande stocké qui correspond à la fréquence sélectionnée par ledit contrôleur de canal externe (DSP).

8. Procédé selon la revendication 7, **caractérisé en ce que** ledit procédé comprend en outre une étape consistant à mettre à jour un signal de commande stocké lorsque ledit signal de sortie (VOUT) a la fréquence sélectionnée par ledit contrôleur de canal externe (DSP).

9. Procédé selon la revendication 7, **caractérisé en ce que** ledit procédé comprend les étapes consistant à :
dériver ladite tension de commande (VCTRL) de la fréquence dudit signal de sortie (VOUT) appliquée à un dispositif de rétroaction (FB) qui divise la fréquence dudit signal de sortie par une valeur fournie par ledit contrôleur de canal externe (DSP),
comparer la fréquence résultant de la division à une fréquence de référence (Xtal), et
générer ladite tension de commande (VCTRL) sous la forme du résultat de la différence de la comparaison.

10. Procédé selon la revendication 7,
**caractérisé en ce que** ledit procédé comprend les étapes consistant à :
comparer ladite tension de commande (VCTRL) à une tension de référence basse prédéterminée (VTL) et à une tension de référence élevée prédéterminée (VTH),
connecter au moins un condensateur (XC1, XC2) en parallèle avec ledit condensateur variable (CV) si ladite tension de commande (VCTRL) atteint ladite tension de référence basse prédéterminée (VTL), et
déconnecter au moins un condensateur (XC1, XC2) dudit condensateur variable (CV) si ladite tension de commande (VCTRL) atteint ladite tension de référence élevée prédéterminée (VTH),
et **en ce que** la fréquence dudit signal de sortie, immédiatement après la connexion au dit condensateur (XC1, XC2), est sensiblement égale à la fréquence dudit signal de sortie immédiatement avant de connecter ledit condensateur.
